Europäisches Patentamt

European Patent Office

Office européen des brevets

(19)

(11) **EP 1 345 318 A1**

(12) **EUROPÄISCHE PATENTANMELDUNG**

(43) Veröffentlichungstag:
**17.09.2003 Patentblatt 2003/38**

(51) Int Cl.[7]: **H03F 1/32**

(21) Anmeldenummer: **02006023.2**

(22) Anmeldetag: **15.03.2002**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **SIEMENS AKTIENGESELLSCHAFT**
**80333 München (DE)**

(72) Erfinder:
- **Jelonnek, Björn, Dr.**
  **89079 Ulm (DE)**
- **Splett, Armin, Dr.**
  **89081 Ulm (DE)**

(54) **Anordnung zur Reduzierung von nichtlinearen Verzerrungen bei einem Ausgangssignal einer Verstärkerstufe**

(57)    Die Erfindung betrifft eine Anordnung zur Reduzierung von nichtlinearen Verzerrungen bei einem Verstärkerstufen-Ausgangssignal einer nach dem "Feed-Forward-Prinzip" ausgebildeten Verstärkerstufe. Dabei gelangt ein Verstärkerstufen-Eingangssignal in einem Hauptzweig an einen Verstärker, dessen nichtlinear-verzerrtes Ausgangssignal an einen Addierer gelangt, mit dessen Hilfe das Verstärkerstufen-Ausgangssignal gebildet wird. Das nichtlinear-verzerrte Ausgangssignal und das Verstärkerstufen-Eingangssignal werden einem Nebenzweig zugeführt, der eine Fehlersignal-Einrichtung aufweist. Diese erzeugt aus dem verzögerten Verstärkerstufen-Eingangssignal und aus dem nichtlinear-verzerrten Ausgangssignal des Verstärkers ein Fehlersignal, das zur Reduzierung von Verzerrungen beim Verstärkerstufen-Ausgangssignal dem Addierer zugeführt wird. Die Fehlersignal-Einrichtung beinhaltet dabei mindestens eine Übertragungseinrichtung, die eine negative Gruppenlaufzeit aufweist.

FIG 2

EP 1 345 318 A1

**Beschreibung**

Anordnung zur Reduzierung von nichtlinearen Verzerrungen bei einem Verstärkerstufen-Ausgangssignal einer Verstärkerstufe

Die Erfindung betrifft eine Anordnung zur Reduzierung von nichtlinearen Verzerrungen bei einem Verstärkerstufen-Ausgangssignal einer Verstärkerstufe.

Zur Kompensation von nichtlinearen Verzerrungen werden Verstärkerstufen nach dem sogenannten "Feed-Forward-Prinzip" ausgebildet. Dabei wird in einem Hauptzweig der Verstärkerstufe ein Verstärkerstufen-Eingangssignal über einen nichtidealen Verstärker geführt, dessen nichtlinear-verzerrtes Ausgangssignal einerseits laufzeitverzögert an einen Addierer und andererseits an einen Nebenzweig geführt wird.

Das Verstärkerstufen-Eingangssignal wird ebenfalls dem Nebenzweig zugeführt, wobei dort aus dem laufzeitverzögerten Verstärkerstufen-Eingangssignal und aus dem nichtlinear-verzerrten Ausgangssignal des Verstärkers ein Fehlersignal gewonnen wird, das zur Verzerrungskompensation an den Addierer geführt wird. Der Addierer bildet aus dem Fehlersignal und aus dem nichtlinear-verzerrten Ausgangssignal des Verstärkers das Verstärkerstufen-Ausgangssignal, wobei durch das Fehlersignal die nichtlinearen Verzerrungen des Verstärkers kompensiert werden.

Beim "Feed-Forward-Prinzip" muss innerhalb des Hauptzweigs das nichtlinear-verzerrte Ausgangssignal des Verstärkers entsprechend einer für die Bestimmung des Fehlersignals im Nebenzweig benötigten Gruppenlaufzeit entsprechend verzögert werden. Eine derartige Verzögerung wird im allgemeinen mit Hilfe einer Verzögerungsleitung mit endlicher elektrischer Güte verwirklicht. Die Verzögerungsleitung weist elektrische Verluste auf, die wiederum den Wirkungsgrad der Verstärkerstufe verschlechtern.

Zur Verringerung der Verluste ist eine entsprechend aufwändige und teure Realisierung der Verzögerungsleitung notwendig, wobei zugleich weitere Dämpfungen durch die Verzögerungsleitung verursacht werden.

Die Aufgabe der vorliegenden Erfindung besteht darin, den Wirkungsgrad einer nach dem "Feed-Forward-Prinzip" ausgebildeten Verstärkerstufe zu verbessern.

Die Aufgabe der Erfindung wird durch die Merkmale des Anspruchs 1 gelöst. Vorteilhafte Weiterbildungen der Erfindung sind in den Unteransprüchen angegeben.

Durch die erfindungsgemäße Ausbildung der Verstärkerstufe wird der Herstellungsaufwand deutlich reduziert.

Aufgrund des erfindungsgemäß ausgestalteten Hauptzweigs ist je nach Anwendungsfall die Verstärkerstufe in Mikrostreifentechnik einfach realisierbar, das benötigte Volumen der "Feed-Forward"-Verstärkerstufe wird reduziert.

Der Wirkungsgrad der Verstärkerstufe wird verbessert, da Verluste innerhalb des Hauptzweigs reduziert werden.

Im Folgenden wird ein Ausführungsbeispiel der Erfindung anhand einer Zeichnung näher erläutert. Dabei zeigt:

FIG 1 ein prinzipielles Schaltbild einer nach dem Feed-Forward-Prinzip ausgebildeten Verstärkerstufe, gemäß dem Stand der Technik,

FIG 2 vergleichend mit FIG 1 ein prinzipielles Schaltbild einer erfindungsgemäßen Verstärkerstufe,

FIG 3 ein prinzipielles Schaltbild einer weiteren erfindungsgemäßen Verstärkerstufe,

FIG 4 ein Ausführungsbeispiel für eine in der Anordnung gemäß FIG 3 vorgesehene Übertragungseinrichtung, und

FIG 5 bis

FIG 7 Übertragungskennlinien des in FIG 4 dargestellten analogen Filters.

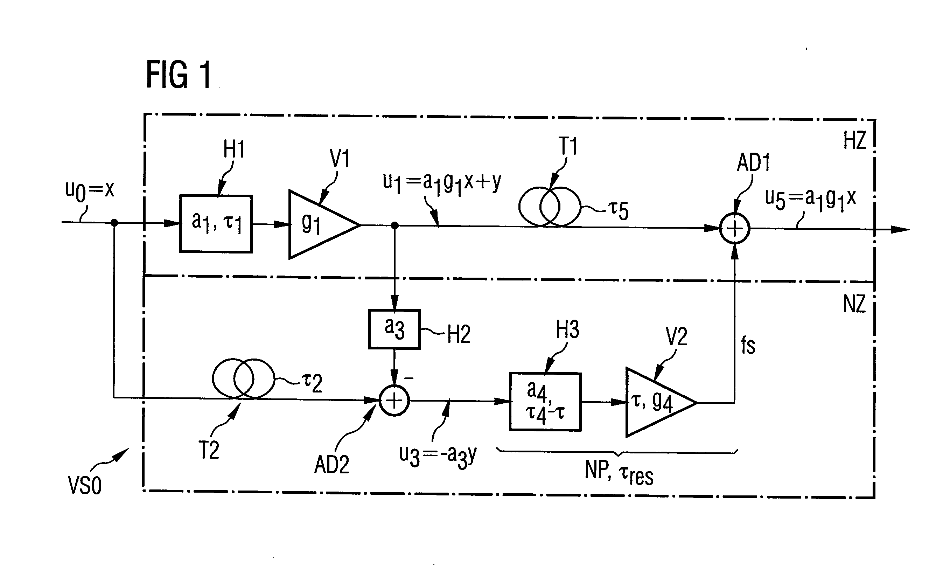

FIG 1 zeigt ein prinzipielles Schaltbild einer nach dem Feed-Forward-Prinzip ausgebildeten Verstärkerstufe VS0, gemäß dem Stand der Technik.

An die Verstärkerstufe VS0 gelangt ein Verstärkerstufen-Eingangssignal u0, das sowohl an einem Hauptzweig HZ als auch an einem Nebenzweig NZ der Verstärkerstufe VS0 als Eingangssignal angeschaltet ist. Durch die Verstärkerstufe VS0 wird ein Verstärkerstufen-Ausgangssignal u5 erzeugt, dessen nichtlineare Verzerrungen mit Hilfe eines durch den Nebenzweig NZ gebildeten Fehlersignals fs reduziert werden.

Der Hauptzweig HZ beinhaltet in Serie geschaltet eine erste Übertragungseinrichtung H1, die eine Dämpfung a1 und eine Gruppenlaufzeit $\tau 1$ aufweist, einen nichtidealen ersten Verstärker V1 mit einer Verstärkung g1, ein Laufzeitglied T1 mit einer Gruppenlaufzeit $\tau 5$ und einen ersten Addierer AD1.

Der Nebenzweig NZ beinhaltet eine Serienschaltung aus einem Laufzeitglied T2 mit einer Gruppenlaufzeit $\tau 2$, einen zweiten Addierer AD2 sowie eine dritte Übertragungseinrichtung H3 mit einer Dämpfung a4 und mit einer Gruppenlaufzeit $\tau 4-\tau$. Der dritten Übertragungseinrichtung H3 ist ein zweiter Verstärker V2 mit einer Verstärkung g4 und mit einer Gruppenlaufzeit $\tau$ nachgeschaltet. Der Nebenzweig beinhaltet weiterhin in einem Querzweig eine zweite Übertragungseinrichtung H2, die einerseits am Ausgang des ersten Verstärkers V1 im Hauptzweig HZ und andererseits am zweiten Addierer AD2 angeschaltet ist.

Die dritte Übertragungseinrichtung H3 und der zweite Verstärker V2 werden zu einer sogenannten Fehlersignal-Einrichtung NP zusammengefasst, deren Ausgangssignal als Fehlersignal fs an den ersten Addierer AD1 gelangt. Die Fehlersignal-Einrichtung NP weist somit eine resultierende Gruppenlaufzeit τres auf, die sich aus den Gruppenlaufzeiten der dritten Übertragungseinrichtung H3 und des zweiten Verstärkers V2 zusammensetzt.

Beim Hauptzweig HZ gelangt das Verstärkerstufen-Eingangssignal u0 über die erste Übertragungseinrichtung H1 an den als nichtideal angenommenen ersten Verstärker V1, dessen nichtlinear-verzerrtes Ausgangssignal u1 einen Fehleranteil y aufweist. Es gilt somit: u1 = a1*g1*x+y mit x=u0.

Durch den ersten Verstärker V1 verursachte Gruppenlaufzeiten werden durch die Gruppenlaufzeit τ1 der ersten Übertragungseinrichtung H1 mitberücksichtigt.

Das nichtlinear verzerrte Ausgangssignal u1 des ersten Verstärkers V1 gelangt einerseits über das Laufzeitglied T1 an den ersten Addierer AD1 und andererseits über die zweite Übertragungseinrichtung H2 negiert an einen zweiten Eingang des zweiten Addierer AD2, wobei an einem ersten Eingang des zweiten Addierers das durch das Laufzeitglied T2 verzögerte Verstärkerstufen-Eingangssignal u0 angeschaltet ist.

Für ein Ausgangssignal u3 des zweiten Addierers AD2, das als Eingangssignal an die Fehlersignal-Einrichtung NP gelangt, gilt somit: u3 = -a3*y, mit τ2 = τ1 und mit a1*g1=1/a3.

Das Eingangssignal u3 der Fehlersignal-Einrichtung NP gelangt über die dritte Übertragungseinrichtung H3 an den zweiten Verstärker V2, dessen Ausgangssignal das Fehlersignal fs ist. Dabei gilt: τ5=τ4 und a3*a4*g4 = 1, wodurch fs = y wird.

An einem ersten Eingang des ersten Addierers AD1 ist das nichtlinear-verzerrte Ausgangssignal u1 des ersten Verstärkers V1 angeschaltet, an einen zweiten Eingang des ersten Addierers AD1 ist das Fehlersignal fs angeschaltet. Der erste Addierer AD1 bildet daraus die Verstärkerstufen-Ausgangsspannung u5. Dabei gilt mit den oben genannten Voraussetzungen: u5 = a1*g1*x.

Die hier dargestellten Verzweigungen und Addierer werden üblicherweise als Richtkoppler realisiert. Phasendrehungen der Spannungen werden hier im einzelnen nicht betrachtet.

Da der zweite Verstärker V2 lediglich den Fehleranteil Y verstärkt, kann er linear betrieben werden, so dass durch ihn nur vernachlässigbare nichtlineare Verzerrungen erzeugt werden.

Das Laufzeitglied T2 ist beispielsweise als Verzögerungsleitung ausgeführt und weist für eine Frequenz f eine Dämpfung A auf, wobei gilt: A = 10dB*$\log_{10}$ (e) $2\pi f\tau_5/Q$ = 27,3dB*f$\tau_5$/Q .

Als weitere Ausführungsform des Laufzeitglieds T2 ist ein Filter möglich, das bei gleicher Güte Q ebenfalls die oben genannte Dämpfung A aufweist.

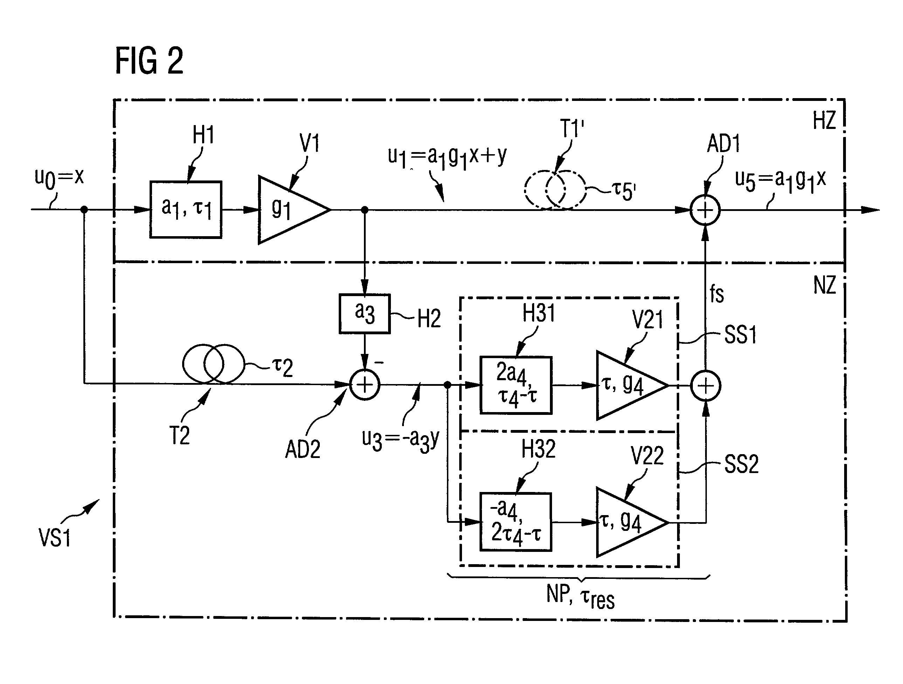

FIG 2 zeigt vergleichend mit FIG 1 ein prinzipielles Schaltbild einer erfindungsgemäßen Verstärkerstufe VS1.

Vergleichend mit FIG 1 wird hier von einem Idealfall ausgegangen, bei dem im Hauptzweig ein Laufzeitglied T1' mit einer Gruppenlaufzeit τ5' derart ausgebildet ist, dass das nichtlinear-verzerrte Ausgangssignal u1 des ersten Verstärkers V1 im wesentlichen verzögerungsfrei an den ersten Addierer AD1 gelangt, wobei diese ideale Voraussetzung mit Hilfe der resultierenden Gruppenlaufzeit τres der Fehlersignal-Einrichtung NP entsprechend berücksichtigt werden muss.

Die Fehlersignal-Einrichtung NP beinhaltet hier zwei Serienschaltungen SS1 und SS2, wobei jede dieser Serienschaltungen eine dritte Übertragungseinrichtung H31 bzw. H32 und der jeweiligen Übertragungseinrichtung nachgeschaltete Verstärker V21 bzw. V22 aufweist.

Bei einer weiteren Ausgestaltungsform ist vorgesehen, mehr als zwei Serienschaltungen parallel zueinander anzuordnen.

Dabei ist es auch möglich, den dritten Übertragungseinrichtungen einen gemeinsamen Verstärker nachzuschalten.

Dabei gilt jedoch stets, dass die resultierende Gruppenlaufzeit τres der Fehlersignal-Einrichtung NP derart gebildet wird, dass eine zwischen dem ersten Verstärker V1 und dem ersten Addierer AD1 auftretende Gruppenlaufzeit t5' entsprechend berücksichtigt wird.

Für den hier beschriebenen Fall "im wesentlichen verzögerungsfrei" ist die resultierende Gruppenlaufzeit τres der Fehlersignal-Einrichtung NP im gewünschten Frequenzbereich negativ zu wählen.

Die Fehlersignaleinrichtung NP weist hier ein digitales Filter auf, wobei die beiden Übertragungseinrichtungen H31 bzw. H32 als Koeffizienten 2*a4 und τ4-τ bzw. -a4 und 2τ4-τ aufweisen.

Die Ausgangssignale der beiden Verstärker V21 und V22 werden mit Hilfe eines weiteren Addierers zum Fehlersignal fs addiert, das wieder an den ersten Addierer AD1 gelangt.

Unter der Bedingung a3*a4*g4=1 gilt für das Verstärkerstufen-Ausgangssignal u5:

$$u_5 = a_1 g_1 \, x + y \, [1-2\exp(-j2\pi f\tau_4)+ \exp(-j2\pi f2\tau_4) \,]$$

Durch eine entsprechend geringe Gruppenlaufzeit $\tau_4$-τ kann die Gruppenlaufzeit τ4 so eingestellt werden, dass ein Produkt $f_0\tau_4$ ganzzahlig ist, wobei $f_0$ hier eine Mittenfrequenz eines Arbeitsbereichs der Verstärker V21 bzw.

V22 ist. Für eine Ablagefrequenz $\Delta f = f-f_0$ gilt dann:

$$u_5 = a_1 g_1 \, x + y \, [1-2\exp(-j2\pi \, \Delta f \tau_4)+ \exp(-j2\pi \, \Delta f \, 2\tau_4)]$$

Mit einer Reihenentwicklung:

$$[1-2\exp(-j2\pi\Delta f\tau_4) + \exp(-j2\pi\Delta f 2\tau_4) \,]$$

$$= -(-j2\pi\Delta f\tau_4)^2 + 2 \, (-j2\pi\Delta f\tau_4)^2 - 1/3 \, (-J2\pi\Delta f\tau_4)^3 + 4/3(-j2\pi\Delta f\tau_4)^3$$

$$+....$$

$$= (-J2\pi\Delta f\tau_4)^2 + (-J2\pi\Delta f\tau_4)^3 + ...$$

ergibt sich eine Unterdrückung von nichtlinearen Verzerrungen beim Fehleranteil Y für kleine Ablagefrequenzen $\Delta f\tau_4$ << 1 im Ausgangssignal $u_5$ um ca. $-20\text{dB}*\log_{10} (2\pi\Delta f\tau_4)$.

Abweichend vom Idealfall wird in der Realität bei der Verstärkerstufe VS1 im Hauptzweig HZ zwischen dem Ausgang des Verstärkers V1 und dem Addierer AD1 das Laufzeitglied T1' mit einer, vergleichend zum Stand der Technik geringeren, Gruppenlaufzeit $\tau 5'$ angeordnet sein. Für diesen Fall werden bei den dritten Übertragungseinrichtungen die negativen Gruppenlaufzeiten derart gewählt, dass die resultierende Gruppenlaufzeit $\tau$res der Fehlersignal-Einrichtung NP die Gruppenlaufzeit $\tau 5'$ ausgleicht, also $\tau$res = $\tau 5'$.

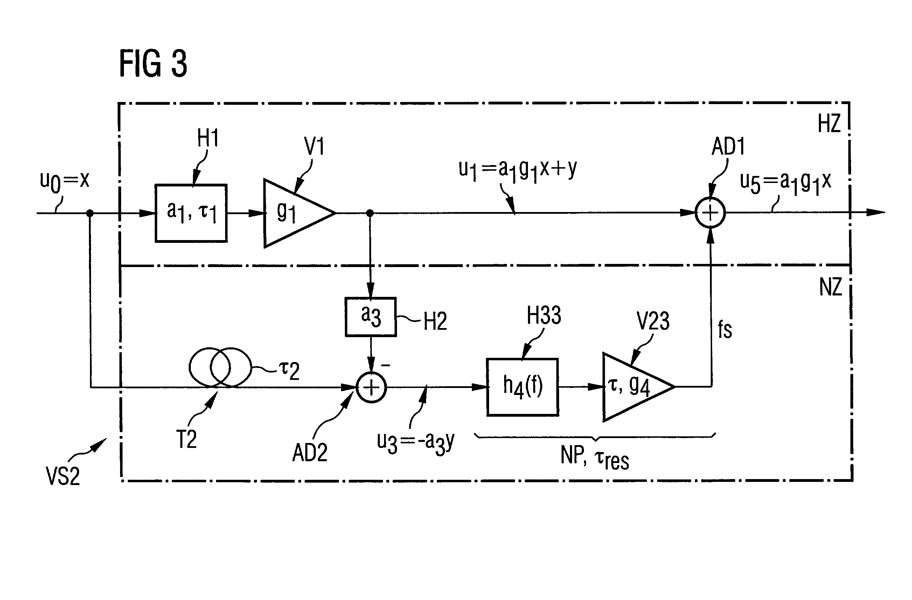

FIG 3 zeigt ein prinzipielles Schaltbild einer weiteren erfindungsgemäßen Verstärkerstufe VS2.

Vergleichend mit FIG 2 besteht hier die Fehlersignal-Einrichtung NP nur aus einer Serienschaltung mit einer dritten Übertragungseinrichtung H33 und einem zweiten Verstärker V23.

Die dritte Übertragungseinrichtung H33 wird beispielsweise durch ein passives Filter mit einer negativen Gruppenlaufzeit gebildet. Das Ausgangssignal des zweiten Verstärkers gelangt wiederum als Fehlersignal fs an den ersten Addierer AD1.

Eine Übertragungsfunktionen $[1-\exp(-j2\pi f\tau_4)]^n$ -1 der Fehlersignal-Einrichtung NP wird für große und ganzzahlige Potenzen "n" in guter Näherung auch mit nur einem Verstärker V23 erreicht, wobei das vorgeschaltete Filter zumindest für kleine Ablagefrequenzen $\Delta f\tau_4$<<1 eine Filterübertragungsfunktion

$$h4 \, (f) = \{[1- \exp(-j2\pi\Delta f\tau_4) \,]^n -1\} * \exp (+j2\pi f\tau)/g_4 \text{ annähert.}$$

Für $\tau_4 > \tau$ ist dies prinzipiell möglich.

Da die als Filter ausgebildete dritte Übertragungseinrichtung H33 nur niedrige Hochfrequenzleistungen überträgt, wird die Einfügedämpfung des Filters vernachlässigt.

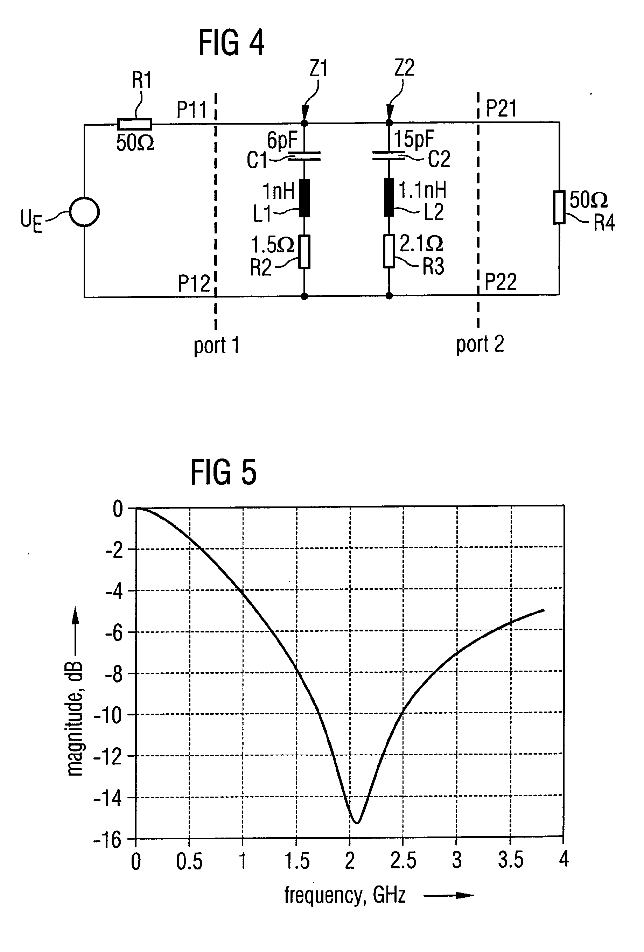

FIG 4 zeigt ein Ausführungsbeispiel für die in der Anordnung gemäß FIG 3 vorgesehene dritte Übertragungseinrichtung H33, die als analoges Filter mit negativer Gruppenlaufzeit ausgebildet ist.

Eine Spannungsquelle uE mit einem Widerstand R1=50$\Omega$ ist an zwei Bezugspunkten P11 und P12 eines ersten Anschlussports port1 angeschlossen. Zwischen den Bezugspunkten P11 und P12 sind ein erster und ein zweiter, parallel zueinander angeordneter Zweig Z1 und Z2 angeschaltet, wobei der erste Zweig Z1 eine Serienschaltung mit einem Kondensator C1=6pF, einer Induktivität L1=1nH und einem Widerstands R2=1,5$\Omega$ aufweist. Der zweite Zweig Z2 weist eine Serienschaltung mit einem Kondensator C2=15pF, einer Induktivität L1=1,1nH und einen Widerstand R3=1,5$\Omega$ auf. Eine Ausgangsspannung kann an einem zweiten Anschlussport port 2 über zwei Bezugspunkte P21 und P22 an einem Widerstand R4=50$\Omega$ abgegriffen werden.

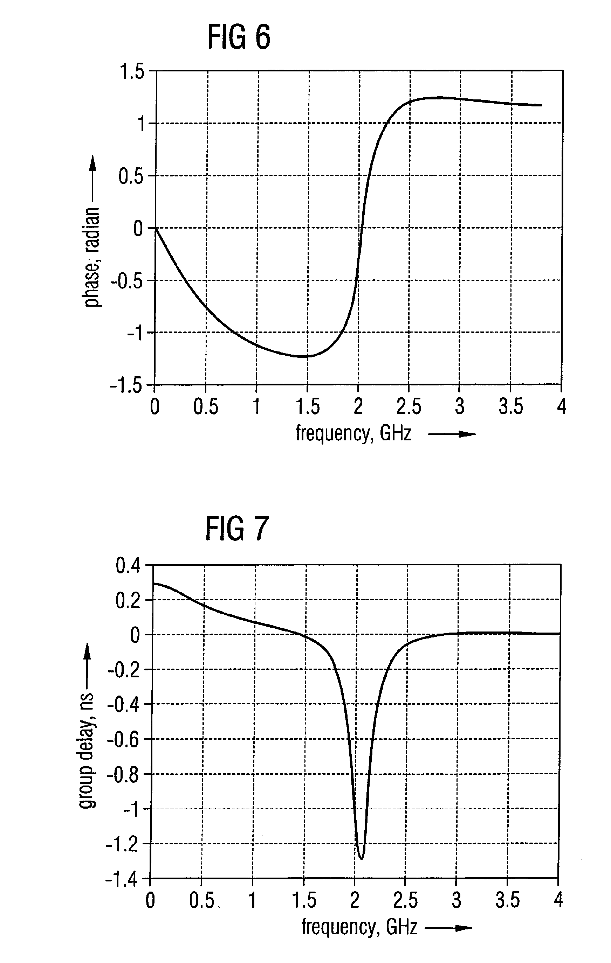

FIG 5 bis FIG 7 zeigen Übertragungskennlinien des in FIG 4 dargestellten analogen Filters.

Fig. 5 zeigt eine frequenzabhängige Übertragungskennlinie, bei der auf der x-Achse Frequenzen in GHz und auf der y-Achse Amplitudenwerte in "dB" aufgetragen sind.

Fig. 6 zeigt eine frequenzabhängige Übertragungskennlinie, bei der auf der x-Achse Frequenzen in GHz und auf der y-Achse Phasen in "radian" aufgetragen sind.

Fig. 7 zeigt abschließend eine frequenzabhängige Übertragungskennlinie, bei der auf der x-Achse Frequenzen in GHz und auf der y-Achse Gruppenlaufzeiten in Sekunden aufgetragen sind.

**Patentansprüche**

1. Anordnung zur Reduzierung von nichtlinearen Verzerrungen bei einem Verstärkerstufen-Ausgangssignal (u5) einer Verstärkerstufe (VS),

   - bei der die Verstärkerstufe (VS) in einem Hauptzweig (HZ) einen ersten Verstärker (V1) und einen ersten Addierer (AD1) aufweist, die derart angeordnet sind, dass ein Verstärkerstufen-Eingangssignal (u0) über den ersten Verstärker (V1) als nichtlinear-verzerrtes Verstärkerausgangssignal (u1) an einen ersten Eingang des ersten Addierers (AD1) zur Bildung des Verstärkerstufen-Ausgangssignals (u5) gelangt,
   - bei der die Verstärkerstufe (VS) in einem Nebenzweig (NZ) einen zweiten Addierer (AD2) aufweist, dem einerseits das Verstärkerstufen-Eingangssignal (u0) laufzeitverzögert und andererseits das nichtlinear-verzerrte Ausgangssignal (u1) des ersten Verstärkers (V1) negiert zugeführt ist, und aus dem Ausgangssignal (u3) des zweiten Addierers (AD2) mit Hilfe einer Fehlersignal-Einrichtung (NP) ein Fehlersignal (fs) gebildet wird, das an einen zweiten Eingang des ersten Addierers (AD1) angeschaltet ist,

   **dadurch gekennzeichnet,**

   - **dass** die Fehlersignal-Einrichtung (NP) mindestens eine Übertragungseinrichtung (H31,H32,H33) mit einer negativen Gruppenlaufzeit und mindestens einen Verstärker mit einer positiven Gruppenlaufzeit aufweist, und
   - **dass** die Gruppenlaufzeiten der Fehlersignal-Einrichtung (NP) derart dimensioniert sind, dass beim Verstärkerstufen-Ausgangssignal (u5) nichtlineare Verzerrungen minimiert werden.

2. Verfahren nach Anspruch 1, **dadurch gekennzeichnet, dass** das Ausgangssignal (u1) des ersten Verstärkers (V1) im wesentlichen verzögerungsfrei an den ersten Addierer (AD1) angeschaltet ist.

3. Verfahren nach Anspruch 1, **dadurch gekennzeichnet, dass** das Ausgangssignal (u1) des ersten Verstärkers (V1) über eine Verzögerungseinrichtung (T1') an den ersten Addierer (AD1) angeschaltet ist.

4. Anordnung nach einem der vorhergehenden Ansprüche, **dadurch gekennzeichnet, dass** dem ersten Verstärker (V1) eine erste Übertragungseinrichtung (H1) vorgeschaltet ist.

5. Anordnung nach einem der vorhergehenden Ansprüche, **dadurch gekennzeichnet, dass** dem zweiten Addierer (AD2) ein erstes Laufzeitglied (T2) zur Verzögerung des Verstärkerstufen-Eingangssignal (u0) und eine zweite Übertragungseinrichtung (H2) zur Negierung und Dämpfung des nichtlinear-verzerrten Ausgangssignals (u1) des ersten Verstärkers (V1) vorgeschaltet ist.

6. Anordnung nach einem der vorhergehenden Ansprüche, **dadurch gekennzeichnet, dass** die Fehlersignal-Einrichtung (NP) mindestens eine Serienschaltung mit einer dritten Übertragungseinrichtung (H31,H32,H33) und mit einem zweiten Verstärker (V21,V22,V23) aufweist.

7. Anordnung nach Anspruch 6, **dadurch gekennzeichnet, dass** die dritte Übertragungseinrichtung (H33) als analoges Filter mit negativer Gruppenlaufzeit in einem gewünschten Frequenzbereich ausgebildet ist.

8. Anordnung nach Anspruch 6, **dadurch gekennzeichnet, dass** die Fehlersignal-Einrichtung (NP) mindestens zwei Serienschaltungen (SS1, SS2) beinhaltet, deren dritte Übertragungseinrichtungen (H31,H32) einen digitalen Filter mit negativer Gruppenlaufzeit in einem gewünschten Frequenzbereich bilden.

FIG 1

EP 1 345 318 A1

FIG 2

EP 1 345 318 A1

FIG 3

EP 1 345 318 A1

# FIG 4

# FIG 5

## FIG 6

## FIG 7

**Europäisches Patentamt**

## EUROPÄISCHER RECHERCHENBERICHT

Nummer der Anmeldung

EP 02 00 6023

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 5 986 500 A (KIM CHUL-DONG ET AL) 16. November 1999 (1999-11-16) * Spalte 14, Zeile 44 - Zeile 51; Abbildung 3 * --- | 1 | H03F1/32 |
| A | EP 0 768 752 A (AT & T CORP) 16. April 1997 (1997-04-16) * Spalte 5, Zeile 54 - Zeile 56; Abbildungen 2,7 * ----- | 1 | |

**RECHERCHIERTE SACHGEBIETE (Int.Cl.7)**

H03F

Der vorliegende Recherchenbericht wurde für alle Patentansprüche erstellt

| Recherchenort | Abschlußdatum der Recherche | Prüfer |
|---|---|---|
| DEN HAAG | 15. Juli 2002 | Segaert, P |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................................
& : Mitglied der gleichen Patentfamilie, übereinstimmendes Dokument

EPO FORM 1503 03.82 (P04C03)

**EP 1 345 318 A1**

**ANHANG ZUM EUROPÄISCHEN RECHERCHENBERICHT
ÜBER DIE EUROPÄISCHE PATENTANMELDUNG NR.**

EP 02 00 6023

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-07-2002

| Im Recherchenbericht angeführtes Patentdokument | | Datum der Veröffentlichung | Mitglied(er) der Patentfamilie | | | Datum der Veröffentlichung |
|---|---|---|---|---|---|---|
| US 5986500 | A | 16-11-1999 | AU | 733748 | B2 | 24-05-2001 |
| | | | AU | 5344698 | A | 31-07-1998 |
| | | | BR | 9713649 | A | 11-04-2000 |
| | | | CN | 1249080 | A | 29-03-2000 |
| | | | EP | 0948838 | A1 | 13-10-1999 |
| | | | JP | 2000508149 | T | 27-06-2000 |
| | | | WO | 9829941 | A1 | 09-07-1998 |
| | | | RU | 2177205 | C2 | 20-12-2001 |
| EP 0768752 | A | 16-04-1997 | US | 5751250 | A | 12-05-1998 |
| | | | DE | 69614217 | D1 | 06-09-2001 |
| | | | DE | 69614217 | T2 | 08-05-2002 |
| | | | EP | 0768752 | A1 | 16-04-1997 |
| | | | JP | 9135124 | A | 20-05-1997 |

EPO FORM P0461

Für nähere Einzelheiten zu diesem Anhang : siehe Amtsblatt des Europäischen Patentamts, Nr. 12/82

12